# EUROPÄISCHE PATENTANMELDUNG

(11) **EP 2 573 832 A2**
(43) Veröffentlichungstag der Anmeldung: **27.03.2013**
(21) Anmeldenummer: 12008289.6
(22) Anmeldetag: 17.03.2009
(51) Int. Cl.: H01L 51/00, B05D 1/34, H01L 51/42

(54) **Organisches elektronisches Bauelement**

(30) Priorität: 20.03.2008 DE 102008015290; 22.08.2008 DE 102008039337
(62) Teilanmeldung aus: 09721503.2
(71) Anmelder: Siemens Aktiengesellschaft, 80333 München (DE)
(72) Erfinder: Fürst, Jens, 91074 Herzogenaurach (DE); Hayden, Oliver, 91074 Herzogenaurach (DE); Kern, Johannes, 91074 Herzogenaurach (DE); Rauch, Tobias, 82256 Fürstenfeldbruck (DE); Sterzl, Tobias, 90408 Nürnberg (DE); Tedde, Sandro Francesco, 91058 Erlangen (DE); Zaus, Edgar, 90765 Fürth (DE)

(57) **Zusammenfassung**

Die Erfindung betrifft organische Bauelemente. Insbesondere betrifft die Erfindung ein Besprühen von Schichten aus mehreren Komponenten, die beispielsweise nicht im gleichen Lösungsmittel lösbar sind und/oder das Besprühen von mehreren Schichten hintereinander. Es werden mehrere Sprühköpfe eingesetzt, beispielsweise hintereinander und/oder nebeneinander.

## Beschreibung

Die Erfindung betrifft ein Verfahren zum Besprühen von Schichten organischer Bauelemente. Insbesondere betrifft die Erfindung ein Besprühen von Schichten aus mehreren Komponenten, die beispielsweise nicht im gleichen Lösungsmittel lösbar sind.

Spray Coating dient als kostengünstiges Polymerbeschichtungsverfahren zur Herstellung elektronischer Bauelemente, wie Solarzellen oder Photodioden auf organischer Basis, wie beispielsweise aus der WO 2003/107453 und der Veröffentlichung von Doojin Vak, Seok-Soon Kim, Jang Jo, Seung-Hwan Oh, Seok-In Na, Juhwan Kim, and Dong-Yu Kima "Fabrication of organic bulk heterojunction solar cells by a spray deposition method for low-cost power generation", APPLIED PHYSICS LETTERS 91, 081102 (2007) bekannt. Insbesondere im Bereich der Solarzellen und Photodetektoren wurden die Effizienzen drastisch durch die Kombination eines Donor-Materials (Absorber und Lochtransportkomponente) und eines Akzeptor-Materials (Elektronenakzeptor und Transportkomponente) in der photoaktiven Schicht des Bauelementes gesteigert. Diese aktive Schicht besteht aus einer Mischung (Blend) dieser zwei Stoffe und ist besser bekannt als "Bulk Heterojunction". Die Trennung der Ladungsträger erfolgt an den Grenzflächen der beiden Materialien, die sich innerhalb des gesamten Schichtvolumens ausbilden. Voraussetzung für solch einen Blend ist, dass die beiden Materialien im gleichen Lösungsmittel lösbar sind. Damit lässt sich die Bulk Heterojunction Lösung mit kostengünstigen Verfahren wie Spin-Coating, Blade-Coating, Slit-Coating, Dip-Coating, Inkjet-Printing, Doktor Blading und Gravur Printing usw., auf das Substrat aufbringen.

Es gibt allerdings Materialien, die vielversprechende elektronische Eigenschaften besitzen, aber nicht im selben Lösungsmittel lösbar sind. Somit ist es unmöglich eine Bulk Heterojunction Lösung aus diesen Materialien herzustellen. Normalerweise werden in diesem Fall Zweischichtsysteme (bilayers) erzeugt, die allerdings auf die positiven Eigenschaften, wie höhere Effizienzen, einer Bulk Heterojunction verzichten müssen.

Ein weiteres, häufig auftretendes Problem, ist die Herstellung von mehrfach gestapelten Polymerschichten (multilayers), die im selben Lösungsmittel lösbar sind. In diesem Fall (z.B. Tandem-OLEDs, Tandem-OPDs oder Tandem-Solarzellen) können die vorher genannten Beschichtungsmethoden leider nicht angewendet werden, da das Aufbringen einer Schicht die darunter liegende Schicht wieder löst, da das die folgende Schicht bildende, Material im gleichen Lösungsmittel aufgebracht wird.

Ein weiterer Nachteil der bislang bekannten Methoden ist, dass mit diesen Auftragsmethoden, in Abhängigkeit des benutzten Lösungsmittel und Auftragsmethode, die maximale erzeugbare Schichtdicke begrenzt ist.

Aufgabe der vorliegenden Erfindung ist daher, die Nachteile des Standes der Technik zu überwinden und ein Bauteil anzugeben, das mittels eines Verfahrens hergestellt wird, mit dem mehrere Komponenten in verschiedenen oder gleichen Lösungsmitteln gleichzeitig auf ein Substrat, dickere Schichten und/oder mehrere Schichten kostengünstig aufgesprüht werden können.

Diese Aufgabe wird durch den Gegenstand der Erfindung, wie er durch die Ansprüche, die Beschreibung und Zeichnungen wiedergegeben wird, gelöst.

Gegenstand der Erfindung ist ein organisches elektronisches Bauelement, ein Substrat, eine untere Elektrode, eine organische aktive Schicht mit darüber einer oberen Elektrode umfassend, wobei die photoleitfähige organische Schicht in Form einer Bulk-Heterojunction mittels einem Verfahren erhältlich ist, bei dem zumindest zwei Sprühköpfe verschiedene oder gleiche Sprühmittel auf eine oder die gleiche Fläche sprühen oder ein Sprühkopf die gleichen Flächen mehrmals besprüht.

Beispielsweise ist eine Vorrichtung zum mehrfachen Besprühen der gleichen Fläche ausgelegt, wenn der Vorratsbehälter unverhältnismäßig groß im Vergleich zur zu besprühenden Fläche ist, dabei ist es vorteilhaft, wenn der Vorratsbehälter fixiert ist und die Sprühköpfe durch eine Zuleitung, die auch flexibel sein kann, versorgt werden. Außerdem ist eine Vorrichtung zum mehrfachen Besprühen der gleichen Fläche ausgelegt, wenn die Halterung an eine Mechanik angeschlossen ist, durch die der Sprühkopf automatisch immer hin- und herbewegt wird, oder wenn in einem Rolle-zu-Rolle Sprühverfahren die Rollen so ausgelegt sind, dass eine Fläche mehrmals unter der Vorrichtung zum Besprühen hin und hergezogen werden kann. Die Walzen des Systems sind dann so ausgelegt, dass sie das kontinuierliche Band, das besprüht wird, in beide Richtungen drehen können. So wird das Substrat mehrere Male unter den sprühenden Sprühkopf durchgeführt. Dadurch wird ermöglicht, dass in einem Beschichtungsprozessschritt beliebige Schichtdicken von den Funktionspolymeren des Bauelements aufgetragen werden.

Als Zerstäuber wird vorliegend ein Teil einer Vorrichtung zum Besprühen bezeichnet, in dem das Sprühmittel durch Zuführen von Gas, insbesondere Umgebungsluft, mit oder ohne Kompressor, zerstäubt wird. Ein herkömmlicher Zerstäuber hat nur einen fest fixierten Sprühkopf, wobei erfindungsgemäß vorgeschlagen wird, dass mehrere Sprühköpfe, die aus verschiedenen oder demselben Vorratsbehälter(n) gespeist werden, den Zerstäuber bilden. Die geometrische Anordnung der Sprühköpfe im Zerstäuber kann beliebig sein, beispielsweise können die Sprühköpfe im Zerstäuber kreisförmig oder halbkreisförmig angeordnet sein. Besonders bevorzugt ist die Ausführungsform, bei der die Sprühköpfe beliebig zu- und abschaltbar sind und/oder die Sprühköpfe in verschiedenen Stellungen fixierbar sind.

Beispielsweise sind die Sprühköpfe im Zerstäuber beweglich angeordnet, so dass die Ausrichtung und/oder die Position der Sprühköpfe gegenüber der zu besprühenden Fläche variabel ist.

Beispielsweise werden mit verschiedenen Sprühköpfen gleiche Sprühmittel aufgetragen, so dass dicke Schichten entstehen. Die Auftragung der Funktionspolymeren mit Hilfe dieses "mehrfachen" Sprühverfahrens erlaubt die Erzeugung von beliebig dicken Schichten und ist integrierbar in Hochdurchsatzfabrikationen, wie Rolle-zu-Rolle Verfahren.

Damit können verschiedene organische elektronische Bauelemente, wie sie Gegenstand der Erfindung sind, beispielsweise voll-sprühbeschichtete Solarzellen, organische Feldeffekttransistoren, organische Kondensatoren, elektrochrome organische Bauteile, organische lichtemittierende Dioden oder organische Photodioden hergestellt werden.

Die Schichtdicke des Lochleiters und des halbleitenden Absorbermaterials kann mit Sprühbeschichtung variabel verändert werden. Dickere Schichten bedeuten eine höhere Absorption der einfallenden Strahlung, was sich in höheren Effizienzen umsetzt und, im Falle von Organischen Photodioden, geringeren Dunkelströmen.

Beispielsweise werden verschiedene Sprühmittel in die einzelnen Sprühkopfe der Vorrichtung eingespeist, so dass die Ausbildung einer, mehrere Komponenten beispielsweise in verschiedenen Lösungsmitteln umfassenden, Schicht ermöglicht wird.

Bevorzugt sind die Sprühköpfe halbkreisförmig angeordnet. Dabei ist die ideale Sprühlinie die Senkrechte auf das zu besprühende Substrat, so dass die Sprühköpfe möglichst dicht um diese Linie angeordnet werden.

Bevorzugt sind die Sprühköpfe fixiert und es wird das zu besprühende Substrat unter den Sprühköpfen bewegt.

Der Einsatz organischer Elektronik nimmt aufgrund der kostengünstigen Herstellungsverfahren und der steigenden Effizienzen von Solarzellen, LEDs, FETs und Photodetektoren kontinuierlich zu. Im Bereich der Solarzellen und Photodetektoren wird die hohe Effizienz durch ein Blend verschiedener organischer Materialien, ein so genanntes Komposit, aus Elektronendonor (Absorber und Lochtransportkomponente; üblicherweise ein halbleitendes Polymer) und einem Elektronenakzeptor (Elektronentransportkomponente; üblicherweise ein Fulleren) - auch bekannt als "Bulk Heterojunction" (BHJ) - erreicht. Die Trennung der Ladungsträger erfolgt an den Grenzflächen der beiden Materialien, die sich innerhalb des gesamten Schichtvolumens ausbilden. Alle Komposite, die durch nasschemische Prozesse aufgetragen werden können, sind attraktiv für die kostengünstige Herstellung der oben erwähnten elektrischen Bauelemente.
Die Halbleiterlösungen können mit Verfahren wie Spin Coating, Blade Coating, Slid Coating, Dip Coating, Spray Coating aufgetragen werden.

Dank der Flexibilität der organischen Halbleiter können Bauelemente auch auf flexiblen Substraten realisiert werden (z.B. PET, PES, PEN) für großflächige Anwendungen wie bei organischen Solarzellen.

In all den vorgenannten Bauelementen wird als Zwischenschicht (zwischen Anode und der "Bulk Heterojunction") eine Lochleiter, wie Poly(3,4-ethylenedioxythiophene)-Poly(styrenesulfonate) (kurz: PEDOT:PSS) verwendet. PEDOT:PSS wird meist auf der Bottom-Elektrode (Anode) aufgebracht, um die Oberfläche zu glätten und Ladungsträgerinjektion bzw. -extraktion zu optimieren (je nachdem, ob es sich um eine Leuchtdiode oder eine Solarzelle oder eine Photodiode handelt). Zudem nützt man diese Lochtransportschicht bzw. Elektronblockierschicht als "Buffer" Schicht, um Kurzschlüsse durch mögliche "spikes" in der Bottom-Elektrode zu vermeiden.

Bislang wurde die PEDOT:PSS Schicht üblicherweise durch Spin-coating oder Doktorblading Verfahren aufgetragen und mit Schichtdicken im Bereich von 80-120nm. Der Grund dafür ist die Erhaltung einer geringen Oberflächenrauhigkeit der Elektrode, um mögliche Kurzschlüsse zu vermeiden. Allerdings bringen Spincoating und Doktorblading den Nachteil dass nur dünne schichten von der Zwischenschicht auftragbar sind. Auch die photoaktive BHJ schicht ist bislang nur mit den oben erwähnten Methoden aufgetragen worden. Im Fall der BHJ ist die Erzeugung von einer dickeren Schicht noch wichtiger da eine höhere Absorption der einfallenden Strahlung gewährleistet wird. Im Fall einer organische Photodiode ist eine dickere BHJ Schicht besonders wertvoll und reduziert auch den Dunkelstrom.

Dickere Schichten (>100µm) sind zudem für Röntgenstrahldetektion vorteilhaft, wie bereits aus der noch unveröffentlichten DE 10 2008 029 782.8 bekannt.

Im Folgenden wird die Erfindung noch anhand von Figuren näher erläutert:
- Figur 1: zeigt eine Ausführungsform einer Vorrichtung zum Besprühen nach der Erfindung, bei der eine Bulk Heterojunction realisiert wird,
- Figur 2a: zeigt eine weitere Ausführungsform der Vorrichtung zum Besprühen, wobei beispielsweise eine Lochleiterschicht aus PEDOT:PSS oder eine dicke Schicht durch mehrfaches Besprühen mit dem gleichen Sprühmittel realisierbar ist,
- Figur 2b: zeigt das Prinzip des mehrfachen Spray Coating mit einer Sprühpistole
- Figur 3: zeigt einen beispielhaften Aufbau einer organischen Photodiode.
- Figur 4: zeigt eine Strom/Spannungskurve eines Bauteils, dessen organische aktive Schicht mit einem Zerstäuber, der mit mehreren Sprühköpfen gleichzeitig die gleiche Fläche besprüht, hergestellt wurde.
- Figur 5: zeigt die Messung einer externen Quanteneffizienz dieses Bauteils. Die Hohe Quanteneffizienz ist ein Beweis dass eine Bulk Heterojunction entstanden ist.
- Figur 6: zeigt die Strom-Spannungskurven für zwei organische Photodioden im Vergleich, wobei die eine Photodiode (dargestellt durch die Dreiecke) eine besprühte PEDOT:PSS Schicht hat und die andere nach dem Stand der Technik über Spin-Coating hergestellt wurde,
- Figuren 7 und 8: zeigen Schichtdickenmessungen mit Hilfe eines Profilometers.
- Figur 9: zeigt eine Stromspannungskennlinie (Dunkelstrom und Lichtstrom) für eine organische Photodiode.

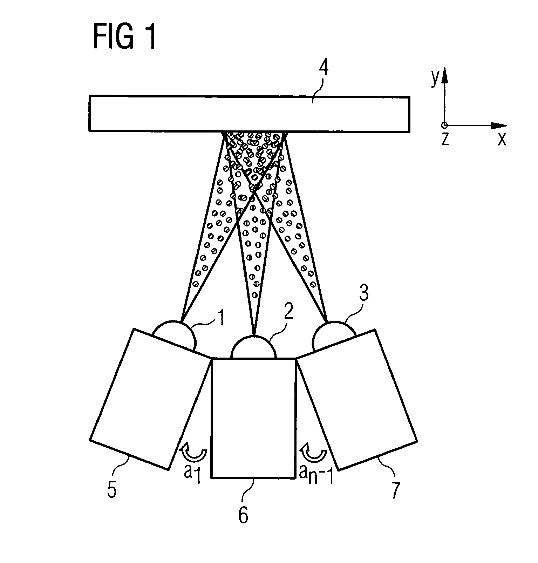

In Figur 1 ist beispielhaft eine Vorrichtung nach der Erfindung gezeigt. Zu erkennen ist oben ein flächiges Substrat 4, in dessen Senkrechter der Sprühkopf 2 angeordnet ist. Die Sprühköpfe 2 und 3, wobei auch weitere Sprühköpfe denkbar sind, sind möglichst nahe an der Senkrechten auf das Substrat angeordnet. Die Anordnung der Sprühköpfe 1 bis 3 ist zwar fixierbar, jedoch können sowohl Sprühköpfe relativ zueinander als auch relativ zum Substrat beweglich sein, sowohl während des Sprühprozesses als auch vor- oder nachher. Hinter den Sprühköpfen befinden sich vorliegend die jeweiligen Tanks 5 bis 7. Die Tanks können beliebig angeordnet sein und auch über entsprechende Versorgungsleitungen mit den Sprühköpfen verbunden sein.

Hier werden mehrere Sprühpistolen (Anzahl beliebig) eingesetzt, um eine Bulk Heterojunction zu erzeugen, die mehrere Stoffe enthält. Diese müssen nicht mehr im selben Lösungsmittel lösbar sein. Für jeden Stoff wird mit einem geeigneten Lösemittel eine Lösung hergestellt, womit die Tanks der verschiedenen Sprühpistolen befüllt werden. Die Sprühdüsen werden schließlich so ausgerichtet, dass die Sprühkreise von den verschiedenen Pistolen auf dem Substrat übereinander liegen. Wichtige geometrische Parameter des Aufbaus sind in diesem Fall die Entfernungen der Düsen vom Substrat und der Winkel zwischen der Normalen/Senkrechten des Substrats und der idealen Sprühlinie. Andere wichtige Parameter sind der Lösungsfluss durch die Pistolendüse und die Feststoff-Konzentration jeder Lösung. Die Polymerlösungen werden durch die Düsen in kleine Tropfen zerstäubt, welche auf das Substrat auftreffen, und sich ablagern. Durch Verdunstung des Lösungsmittels bildet sich eine Polymerschicht.

Üblicherweise sind die Sprühpistolen fest fixiert, und das Substrat wird definiert unter den Sprühköpfen vorbeigezogen. Auch andere Ausführungen, wobei sich die Sprühköpfe oder Sprühköpfe und Substrat bewegen, sind denkbar.

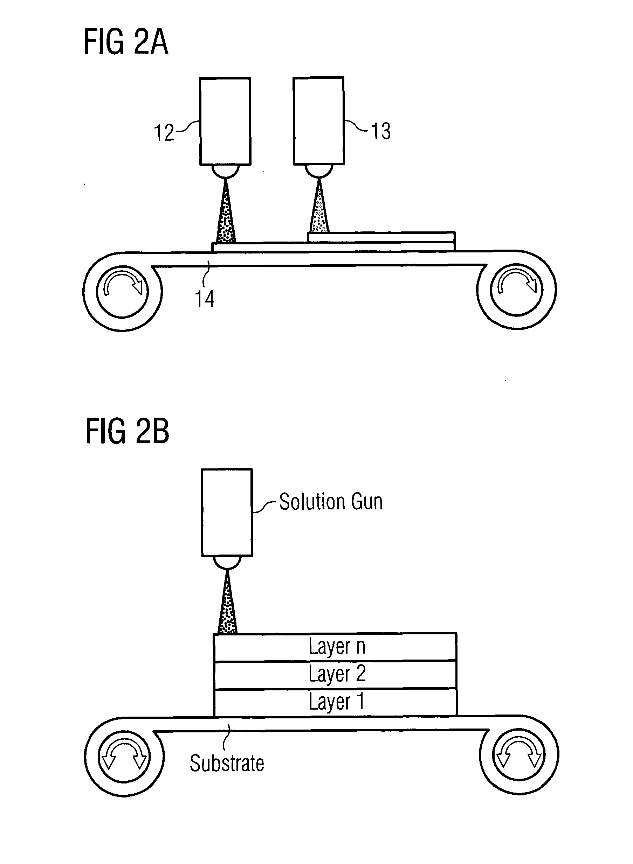

Figur 2a zeigt eine Ausführungsform, in der zwei Sprühköpfe oder Sprühpistolen hintereinander angeordnet sind, so dass zwei separate Schichten unmittelbar hintereinander aufgesprüht werden. So kann beispielsweise eine Rolle-zu-Rolle-Sprühbeschichtung realisiert werden. Hier sind die Sprühköpfe 12 und 13 hintereinander angeordnet, so dass sie zwar gleichzeitig, aber verschiedene Bereiche auf dem kontinuierlichen Bandsubstrat 14 also verschiedene Flächen eines kontinuierlich über zwei Rollen gezogenen Endlos-Substrates 14, besprühen. Ebenso gut können natürlich drei oder mehr Sprühköpfe hintereinander angeordnet sein. Dabei können zum einen gleiche Sprühmittel besprüht werden oder auch verschiedene Sprühmittel.

Sprühbar sind all die halbleitenden Materialien für organische elektronische Bauteile nach der Erfindung. Beispiele für im Sinne der Erfindung sprühbare Materialien sind: PEDOT:PSS, ein Lochleitermaterial. Dieses Material wird in verschiedenen organischen elektronischen Bauteilen wie beispielsweise organischen Photodetektoren, Solarzellen, organischer Photovoltaik, und/oder in organischen lichtemittierenden Dioden verwendet. Dabei kann das unverdünnte flüssige Material gesprüht werden oder eine wässrige Lösung davon, wobei im Verhältnis 1:0 (unverdünnt) bis 1:1000 (1 Teil PEDOT:PSS für 1000 Teile Wasser) variiert werden kann.

P3HT, MDMO-PPV und/oder MEH-PPV:PCBM ist Bulk Hetero Junction, wird ebenfalls bei verschiedenen organischen elektronischen Bauteilen wie beispielsweise organischen Photodetektoren, Solarzellen, organischer Photovoltaik, und/oder in organischen lichtemittierenden Dioden eingesetzt. Das Gewichtverhältnis zwischen den beiden Materialien kann in einer Bandbreite vom Verhältnis 1:0,5 bis 1:5 eingesetzt werden. Der Festkörperanteil in der Lösung ist abhängig von der Löslichkeit im Lösungsmittel und kann im Bereich von 5% bis 0,001% (Gewichtverhältnis) variieren.

PCBM ([60]PCBM ) ist ein Fulleren Derivat. Es kann in folgenden Derivaten vorliegen und gemäß der Erfindung gesprüht werden:
[70]PCBM
[84]PCBM
[60] ThCBM
[60]PCB-A
[60] PCB-Cₙ

Zusätzlich gibt es auch noch die Möglichkeit Nanokristalle (Quantum dots) in die Lösung einzumischen: CdSe, CdTe, PbSe, PbS. (Mögliche Schichtdicken von 50nm bis 1mm). Zum Beispiel für NIR (near infrared) Detektoren oder im Falle der Direkt Konversion von Röntgenstrahlen

Figur 2b zeigt das Prinzip des mehrfachen Spray Coating Systems mit einer einzigen Sprühpistole. Als Beispiel ist ein Rolle-zu-Rolle Herstellungsverfahren dargestellt. Hier wird das Substrat, ein Bandsubstrat, mehrere Male unter dem sprühenden Sprühkopf geführt. Dies ermöglicht, mit derselben Beschichtungsmethode beliebige Schichtdicken von Funktionspolymeren des Bauelements aufzutragen. Bei der kontinuierlichen Rolle-zu-Rolle Beschichtung wird ein flexibles Bandsubstrat eingesetzt, das aufgerollt werden kann. Die vorliegende Erfindung ist jedoch genauso gut auch für starre Substrate einsetzbar, da die Vorrichtung zum Besprühen auch mit einem mobilen Sprühkopf ausgestattet sein kann, der ein starres und fixiertes Substrat abfährt. Schließlich kann ein starres Substrat auch mehrmals unter eine, Sprühkopf durchgeführt werden. Jedenfalls sind alle Varianten im Sinne der Erfindung, die zu einer mehrmaligen Besprühung führen.

Gezeigt ist das Prinzip des Rolle-zu-Rolle Spray Coating Systems. Verschiedene Sprühpistolen 12 und 13 können zum Einsatz kommen in Abhängigkeit von der Anzahl der Lagen, die das Bauelement hat. So ist es möglich all die Funktionspolymere des Bauelementes mit derselben Beschichtungsmethode aufzutragen.

Bislang wurde die PEDOT:PSS Schicht durch Spin-Coating oder Doctor Blading Verfahren aufgetragen. Der Grund dafür ist das Bestreben, die geringe Oberflächenrauhigkeit der Elektrode beizubehalten, um mögliche Kurzschlüsse zu vermeiden. Allerdings bringen Spin-Coating und Doctor Blading den Nachteil dass ein Rolle-zu-Rolle Prozess nicht möglich ist. Spray Coating oder Herstellung durch Besprühen der Lochleiterschicht, z.B. aus PEDOT:PSS mit Sprühkopf 12 vor der Aufbringung der aktiven Schicht mit dem Sprühkopf 13 bietet den Vorteil, dass organische elektronische Bauelemente vollständig mit einer einzigen Prozesstechnik hergestellt werden können. Zudem kann mit Spray Coating die Schichtdicke wahlweise eingestellt werden. Dies ist aufgrund der Technik bzw. der begrenzten Löslichkeit von organischen Halbleitern bei Spin Coating oder Doctor Blading nicht möglich. Beispielsweise kann eine Lochleitschicht mit der Vorrichtung nach der Erfindung in Schichtdicken von 50nm bis 1000nm so erhalten werden. Mögliche Schichtdicken der Bulk-Heterojunction P3HT:PCBM-Schicht liegen im Bereich von 50nm bis 1mm.

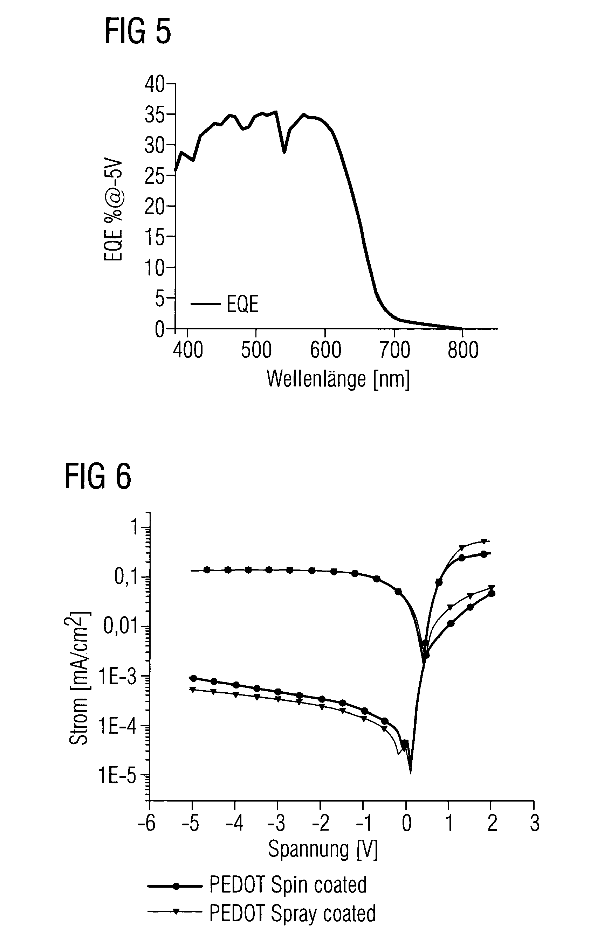

Spray Coating Teststrukturen mit gesprühtem Lochleiter, Sprühkopf 12 (PEDOT:PSS) und Halbleiterkomposit, Sprühkopf 13 (P3HT-PCBM-Blend) zwischen ITO-Bottom-Elektrode und Ca/Ag Top-Elektrode mit funktionstüchtigen Photodioden wurden hergestellt. Stromspannungskennlinien von zwei unterschiedlichen Photodioden, eine mit gesprühter Lochleitschicht und eine mit spin gecoateter Lochleitschicht sind in der Figur 6 dargestellt. Wie man erkennen kann sind die Kennlinien fast identisch. Dieses Ergebnis ist insofern überraschend, da die hohe Rauhigkeit vom sprühbeschichtetem PEDOT:PSS zu Kurzschlüssen führen kann. Es wurden optische Mikroskopaufnahmen von PEDOT:PSS Schichten, die mit unterschiedlichen Beschichtungsmethoden aufgetragen wurden, gemacht. Für jede Beschichtungsmethode wurde zusätzlich auch eine 3D Aufnahme dargestellt, die mit einem Profilometer erzeugt wurde. Der Vergleich zeigte erwartungsgemäß, dass PEDOT:PSS Schichten mit Abschleudern und Doctor Blading eine geringere Rauhigkeit aufweisen (< 10 nm im Durchschnitt) als durch Sprühbeschichtung (>50 nm).

Die Morphologie der Blendschicht ist abhängig von mehreren Parametern, wie beispielsweise der Tropfengröße der gesprühten Lösung. Die Tropfchengröße kann die Phasenseparation zwischen den Materialien im Blend beeinflussen und damit auch die Extraktions-Eigenschaften der Ladungsträgern. Die Morphologie der Blendschicht hat auch Einfluss auf die Mobilität der Ladungsträger und auf den spezifischen Widerstand der Schicht.

Mit der beschriebenen Vorrichtung ist es zusätzlich möglich, Mehrschichtsysteme auf einfache Weise herzustellen. Dazu werden lediglich eine oder mehrere Sprühköpfe abgeschaltet, während die anderen weiter sprühen. Das Mehrschichtsystem wird dadurch erzeugt, dass die unterschiedlichen Sprühköpfe mehrfach über den gleichen Ort auf dem Substrat bewegt werden. Mit Hilfe dieser Methode ist es möglich, Mehrschichtsysteme aus reinen Stoffen oder auch Mehrschichtsysteme aus verschiedenen Blends oder Mischungen zu erzeugen.

Das hier vorgeschlagene Verfahren wurde bei der Herstellung von organischen Photodioden getestet. Es kann aber ebenso gut alle weiteren Sprühverfahren bei beispielsweise anderen organischen elektronischen Bauelementen, wie Solarzellen, Leuchtdioden, Feld-Effekt-Transistoren eingesetzt werden. Es versucht mit Hilfe eines Zerstäubers mit mehreren Sprühköpfen eine Bulk Heterojunction zu erzeugen.

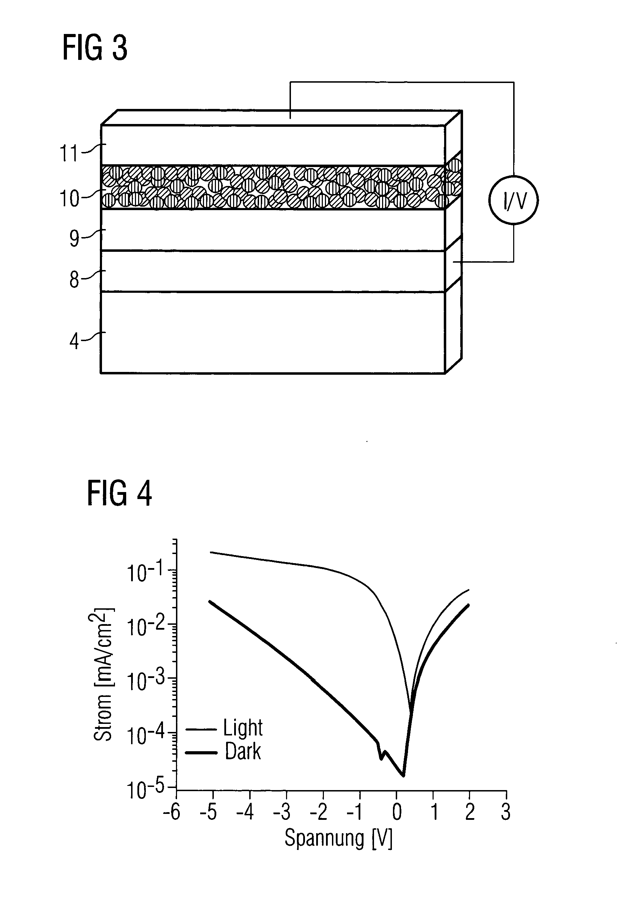

Figur 3 zeigt eine organische Photodiode, die für diesen Test hergestellt wurde. Sie umfasst auf einem Substrat 4 eine untere, bevorzugt transparente Elektrode 8, darauf eine Lochleitschicht 9, bevorzugt eine PEDOT/PSS Schicht und darüber eine organische photoleitfähige Schicht 10 in Form einer Bulk-Heterojunction mit darüber einer oberen Elektrode 11. Beispielsweise bestehen die Schichten aus einem vertikalen Schichtsystem: ITO (Bottom-Elektrode) / PEDOT:PSS / P3HT-PCBM (Spray Coated Blend) / Ca/Ag (Top-Elektrode). Selektive Elektroden sind nötig, um ein Diodenverhalten des Devices zu gewährleisten. Der Blend aus den beiden Komponenten P3HT (Polythiophen: Absorber und Lochtransportkomponente) und PCBM (Fullerene Derivat: Elektronenakzeptor und Transportkomponente) ist die lichtabsorbierende Schicht und wirkt als "Bulk Heterojunction". Eine von zwei zur Herstellung verwendeten Sprühköpfe wurde mit in Chloroform gelösten P3HT betrieben, während in dem anderen Sprühkopf eine Xylol-Lösung mit PCBM enthalten war.

Die PEDOT/PSS Schicht ist die optionale Lochtransportschicht 9. Zusätzlich zu den hier gezeigten Schichten ist der Schutz des Bauteils mittels einer Verkapselung nötig.

Es wurden optische Mikroskop-Aufnahmen von dem P3HT/PCBM-Blend, der mit dem multiplen Spray Coating System hergestellt wurde, gemacht. Die beiden Düsen hatten denselben Abstand vom Substrat und dieselbe Lösungsflusseinstellung sowie auch dieselben Druckparameter an den Sprühköpfen. Bei den Bildern konnte man deutlich eine für Sprühschichten typische inhomogene Schicht erkennen. Eine Separation zwischen den beiden Materialien war allerdings nicht zu erkennen, was die Einsetzbarkeit der erfindungsgemäßen Vorrichtung zeigt.

Figur 4 zeigt die gemessenen I-V Kurven des organischen Photodetektors, dessen photoaktive Blend-Schicht aus P3HT/PCBM mit dem erfindungsgemäßen Verfahren hergestellt wurde. Die gemessene externe Quanteneffizienz (EQE) in Figur 5 zeigt, dass die hergestellte Bulk-Heterojunction die gewünschte Funktionalität hat.

Figur 6 zeigt die Stromspannungskennlinien (Dunkelstrom und Lichtstrom) für zwei organischen Photodioden mit einem Aufbau gemäß Figur 3: Substrat: Glas, Bottom-Elektrode: ITO, Zwischenschicht: PEDOT:PSS, photoaktive Schicht: "Bulk Heterojunction" aus einen blend von P3HT und PCBM, Top-Elektrode: Ca/Ag. Die Kennlinien unterscheiden sich kaum, obwohl PEDOT:PSS in einem Fall durch Spin-Coating (●) und durch Spray Coating (▼) aufgebracht wurde. (Belichtungsintensität ∼780 pW/cm²).

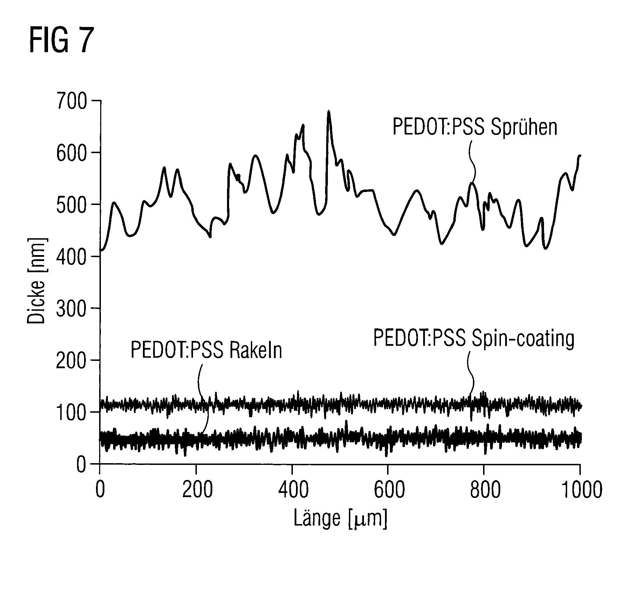

Figur 7 schließlich zeigt eine Schichtdickenmessung mit Hilfe eines Profilometers für die verschiedenen Beschichtungstechniken. Mit Spray Coating kann man beliebig dicke PEDOT:PSS Schichten herstellen.

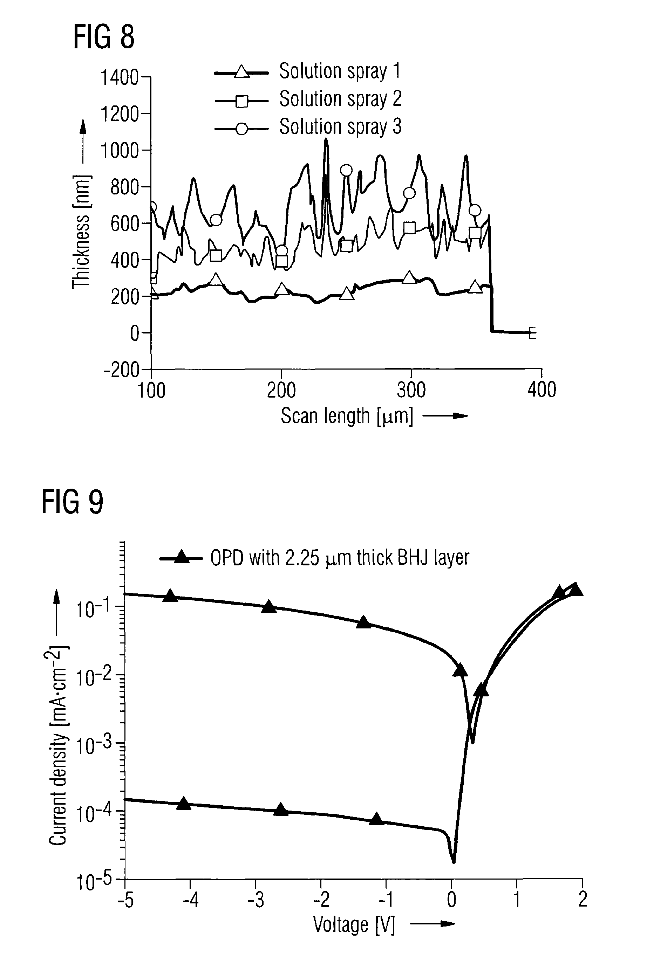

Figur 8 zeigt eine Schichtdickenmessung mit Hilfe eines Profilometers die drei mittels eines mehrfachen Spray Coating Systems gesprühte Schichten aus PEDOT:PSS mit einzelner Sprühpistole, wie in Figur 2b gezeigt, darstellt. Der Mittelwert der Schichtdicke steigt linear mit steigender Anzahl an Sprühgängen. Es ist zu erkennen, dass mühelos, im kontinuierlichen Rolle-zu-Rolle Prozess 800nm dicke Schichten herstellbar sind. Der Graph mit den Dreiecken, die unterste Linie, zeigt die Schichtdicke einer einmal gesprühten Schicht. Die darüberliegende Linie mit den Vierecken zeigt die Schichtdicke einer zweimal gesprühten Schicht und die oberste Linie mit den Kreisen zeigt schließlich, die dreimal gesprühte Schicht, die bis über 1000 nm dick ist. Eine nach der Erfindung gesprühte Schicht ist demnach problemlos mit einer Schichtdicke von 350nm oder mehr herstellbar.

Figur 9 zeigt zum Beispiel eine Stromspannungskennlinie (Dunkelstrom und Lichtstrom) für eine organische Photodiode mit einem Aufbau wie er beispielsweise in Figur 3 gezeigt ist (Substrat: Glas, unter, transparente Bottom-Elektrode: ITO, lochleitende Zwischenschicht: PEDOT:PSS, photoaktive Schicht: "Bulk Heterojunction" (BHJ) aus einen blend von P3HT und PCBM, Top-Elektrode: Ca/Ag). Die beiden Funktionspolymerschichten wurden durch das Spray Coating Verfahren nach der Erfindung aufgetragen. Die PEDOT:PSS Schicht ist ∼200nm dick, während die photoaktive BHJ Schicht durch ein dreifaches, also mehrfaches Spray Coating Verfahren nach der Erfindung mit einzelner Sprühpistole, wie in Figur 2b gezeigt, erzeugt wurde und ∼2.25 µm dick ist.

Mit dieser Erfindung wird die Herstellungstechnik von organischen Bauelementen für großflächige Anwendungen vereinfacht und die Herstellung von beliebig einstellbaren Funktionspolymerschichtdicken ermöglicht. Damit können Devices mit variabler Schichtdicke von Lochleiter und Halbleiter durch Sprühverfahren hergestellt werden.

Spray Coating ermöglicht mehrere Schichten aufeinander zu sprühen ohne die bisherigen unteren Schichten zu lösen. Dickere Schichten können dann erzeuget werden mittels mehrerer Sprühgänge auf einen Punkt und/oder Fläche.

Die Erfindung betrifft ein organisches elektronisches Bauelement, welches insbesondere durch ein Besprühen von Schichten aus mehreren Komponenten, die beispielsweise nicht im gleichen Lösungsmittel lösbar sind, und/oder das Besprühen von mehreren Schichten hintereinander, insbesondere einer Lochleitschicht beispielsweise aus PEDOT/PSS oder mehrere Schichten aus einer Komponente zur Erzeugung dicker Schichten hergestellt wird. Es werden mehrere Sprühköpfe eingesetzt, beispielsweise hintereinander und/oder nebeneinander.

## Patentansprüche

1. Organisches elektronisches Bauelement, ein Substrat, eine untere Elektrode, eine organische aktive Schicht mit darüber einer oberen Elektrode umfassend, wobei die photoleitfähige organische Schicht in Form einer Bulk-Heterojunction mittels eines Verfahrens, bei dem verschiedene Sprühmittel gleichzeitig auf die gleiche Fläche gesprüht werden, erhältlich ist.

2. Organisches elektronisches Bauelement, ein Substrat, eine untere Elektrode, eine organische Zwischenschicht, eine organische photoaktive Schicht mit darüber einer oberen Elektrode umfassend, wobei die organische photoaktive Schicht als Bulk-Heterojunction und eine organische Zwischenschicht mittels eines Verfahrens, bei dem verschiedene Sprühmittel gleichzeitig auf die gleiche Fläche gesprüht werden, herstellbar ist.

3. Organisches elektronisches Bauelement nach Anspruch 1 oder 2, wobei zumindest eine der Schichten mehr als 350 nm dick ist.
